**Europäisches Patentamt**

**European Patent Office**

**Office européen des brevets**

(11) Veröffentlichungsnummer: **0 247 994**
**A2**

# (12) EUROPÄISCHE PATENTANMELDUNG

(21) Anmeldenummer: 87890108.1

(22) Anmeldetag: 20.05.87

(51) Int. Cl.⁴: **H 02 H 7/093**

(30) Priorität: 27.05.86 AT 1420/86

(43) Veröffentlichungstag der Anmeldung: 02.12.87
**Patentblatt 87/49**

(84) Benannte Vertragsstaaten: BE CH DE ES FR GB IT LI NL
SE

(71) Anmelder: AUSTRIA Antriebstechnik G. Bauknecht
Aktiengesellschaft, G.-Bauknecht-Strasse 1,
A-8740 Zeltweg-Spielberg (Steiermark) (AT)

(72) Erfinder: Beckord, Ulrich, Dipl.-Ing., Westende 5,
A-8720 Pausendorf (Steiermark) (AT)
Erfinder: Ott, Josef, Landschacherstrasse,
A-8720 Knittelfeld-Apfelberg/Steiermark (AT)

(74) Vertreter: Beer, Manfred, Dipl.-Ing. et al, Patentanwälte
Dipl.-Ing. Otto Beer, Dipl.-Ing. Manfred Beer
Lindengasse 8, Postfach 462, A-1071 Wien (AT)

(54) Verfahren und Einrichtung zur Feststellung des Stillstandes eines Elektromotors.

(57) Das nach dem zum Einleiten des Stillstandes erfolgten Abschalten der Versorgungsspannung vom auslaufenden Elektromotor (1) durch den Remanenzmagnetismus generierte, induktiv induzierte Wechselspannungssignal wird über die Spannungsversorgungsleitungen ausgekoppelt und mit einem vorgebbaren Grenzwertsignal verglichen. Bei Unterschreitung dieses Grenzwertsignals wird ein Stillstandssignal zur Weiterverwendung bereitgestellt.

## Verfahren und Einrichtung zur Feststellung des Stillstandes eines Elektromotors

Die Erfindung betrifft ein Verfahren zur Feststellung des Stillstandes eines Elektromotors, insbesondere eines Drehstrom-Asynchronmotors, sowie eine Einrichtung zur Durchführung dieses Verfahrens.

Für viele Anordnungen mit Elektromotoren als Antriebsquelle ist es heutzutage aus verschiedenen Gründen unumgänglich, Vorkehrungen dafür zu treffen, daß der Stillstand des Antriebsmotors zuverlässig erkannt bzw. festgestellt werden kann. Insbesondere von Bedeutung ist dies natürlich bei Elektromotoren, die nachgeschaltete Einheiten mit relativ großer Masse bewegen, da dabei die Zeit, die nach dem Abschalten der Versorgungsspannung bis zum sicheren Stillstand des Antriebes verstreicht, relativ groß werden kann. Da für bestimmte Anwendungsfälle, wie beispielsweise bei Waschmaschinen, Wäscheschleudern od. dgl., die Masse des anzutreibenden Bauteils - also im genannten Fall die Masse der Wäschetrommel samt Wäsche - auch in weiten Grenzen variieren kann, ist die bis zum tatsächlichen Stillstand des Antriebes vergehende Zeit auch in weiten Grenzen variabel, was die Festsetzung einer empirisch ermittelten Stillstandszeit einerseits aus Sicherheitsgründen und anderseits aus Gründen einer möglichst kurzen Programmlaufzeit verbietet.

Es sind nun Verfahren bzw. Einrichtungen der eingangs genannten Art bekannt geworden, welche darauf basieren, daß in verschiedenstem Zusammenhang und für verschiedene Zwecke der Steuerung und Regelung des Antriebes Drehzahlaufnehmer am Elektromotor bzw. an geeigneter anderer Stelle des Antriebes ohnedies vorgesehen sind, die beispielsweise auf kapazitivem oder induktivem Weg ober auch unter Verwendung einer Lichtschranke den Vorbeigang von Drehmarken od. dgl. detektieren und in einer Auswerteschaltung zu einem drehzahlproportionalen Signal verarbeiten (siehe beispielsweise DE-A-31 43 590, bei der zusätzlich zum Antriebsmotor noch ein eigener Generator vorgesehen ist, oder DE-A-32 26 073, welche einen zusätzlichen induktiven Geber verwendet). Wenn nun dieses drehzahlproportionale Signal einen bestimmten Stillstandspegel unterschreitet, kann der tatsächliche Stillstand des Elektromotors bzw. des Antriebes unabhängig von der ausgeschalteten Versorgungsspannung angenommen und entsprechend weitergemeldet bzw. verarbeitet werden.

Aus der DE-A-19 54 608 ist eine Anordnung mit Kommutator-Motor bekannt, der zeitweise als Generator betrieben wird. Dazu wird der Motor als Generator im Nebenschlußbetrieb erregt, um so die zur Verriegelung der Maschinentür notwendige Leistung für ein Relais abzugeben, was aber zusätzliche Erregerelemente erfordert.

Nachteilig ist bei allen genannten Anordnungen der relativ hohe Aufwand für die Drehzahlmessung, der sich insbesonders dort negativ auswirkt, wo eigentlich nur der tatsächliche Stillstand des Elektromotors bzw. des Antriebes wesentlich ist, nicht aber die Kenntnis der jeweiligen Drehzahl.

Aufgabe der vorliegenden Erfindung ist es, ein Verfahren bzw. eine Einrichtung der eingangs genannten Art so auszubilden, daß auf einfache und betriebssichere Weise der Stillstand des Elektromotors - und hier insbesondere eines Drehstrom-Asynchronmotors - festgestellt bzw. weitergemeldet werden kann.

Bei einem Verfahren der eingangs genannten Art wird diese Aufgabe dadurch gelöst, daß nach dem zur Einleitung des Stillstandes erfolgten Abschalten der Versorgungsspannung ein vom auslaufenden Elektromotor durch den Remanenzmagnetismus generiertes, induktiv induziertes Wechselspannungssignal über die Spannungsversorgungsleitungen ausgekoppelt wird, daß dieses in Frequenz und Amplitude der Drehzahl des auslaufenden Elektromotors proportionale Signal nach Elimierung der Gleichspannungsanteile mit einem vorgebbaren Grenzwertsignal verglichen wird, und daß bei Unterschreitung' des Grenzwertsignals ein Stillstandssignal erzeugt und zur Weiterverwendung zur Verfügung gestelt wird. Zufolge dieses Verfahrens ist also kein zusätzlicher Hardware-Aufwand für einen Drehzahlaufnehmer od. dgl. am Elektromotor erforderlich; das durch den physikalischen Effekt des Remanenzmagnetismus im auslaufenden Elektromotor generierte, schwache Wechselspannungssignal wird unmittelbar als Maß für die noch vorhandene Drehzahl des bereits von seiner Spannungsversorgung getrennten Elektromotors verwendet und ermöglicht auf einfache Weise - durch den Vergleich mit einem an sich beliebig vorgebbaren Grenzwertsignal - die Anzeige bzw. Weiterverarbeitung des tatsächlichen Stillstandes des Elektromotors. Soferne das Stillstandssignal aus Gründen der Vereinfachung des Vergleiches mit dem Grenzwertsignal bereits bei noch geringen Drehzahlen des auslaufenden Elektromotors erzeugt wird - typisch könnte man hier etwa an ein bis drei Umdrehungen pro Minute zum Zeitpunkt der Erzeugung des Stillstandssignals denken - so kann bei der Weiterverwendung dieses Stillstandssignals noch ein geringer Sicherheitszeitraum - typischerweise im Bereich von einigen wenigen Sekunden - vorgesehen werden, nach dessen Ablauf weitere Funktionen oder Einrichtungen abgerufen bzw. betätigt werden können.

Bei einer Einrichtung zur Durchführung des erfindungsgemäßen Verfahrens zur Feststellung des Stillstandes eines über eine Drehstrombrücke mit je Brückenzweig zwei Leistungstransistoren gesteuerten Elektromotors kann in vorteilhafter Ausgestaltung der Erfindung vorgesehen sein, daß nach dem zur Einleitung des Stillstandes erfolgten Sperren aller sechs Leistungstransistoren einer aus dem unteren Teil eines Brückenzweiges mittels einer Steuerelektronik so wieder durchschaltbar ist, daß die zugehörige Phase der Drehstrombrücke an Masse liegt und daß eine vom so durchschaltbaren Leistungstransistor unabhängige Phase der Spannungsversorgung des Elektromotors über einen Kondensator mit einem Eingang eines Komparators verbunden ist, an dessen anderem Eingang der Mittelpunkt eines einerseits an Masse und anderseits an einer Vergleichsspannung liegenden Spannungsteiles liegt, und daß der Ausgang des Komparators mit einer Auswerteschaltung für das Stillstandssignal verbunden ist. Abgesehen von den Bauteilen zur Aufbereitung bzw. Verarbeitung des vom Elektromotor induktiv induzierten Wechselspannungssignals ist also nur eine Steuerelektronik erforderlich, welche nach dem zur Einleitung des Stillstandes erforderlichen Sperren aller Leistungstransistoren einen davon wieder durchschaltet, was an sich überhaupt keinen zusätzlichen Aufwand bedeutet und mit den zur Motorsteuerung ohnedies erforderlichen Elementen realisiert werden kann. Der Spannungsteiler, der nach einer anderen Weiterbildung der Erfindung auch einstellbar sein kann, ermöglicht auf sehr einfache Weise die Vorgabe des Grenzwertsignals, bei dessen Unterschreitung durch das vorher über den Kondensator gesiebte Wechselspannungssignal der Komparator das Stillstandssignal abgibt.

Der komparatorseitige Anschluß des Kondensators kann nach einer anderen Weiterbildung der Erfindung über ein bei Überspannung durchschaltendes Element, insbesonders eine Z-Diode, an Masse liegen, womit Beschädigungen der Auswerteelektronik durch allenfalls auftretende Überspannungen aus der Leistungselektronik verhindert werden.

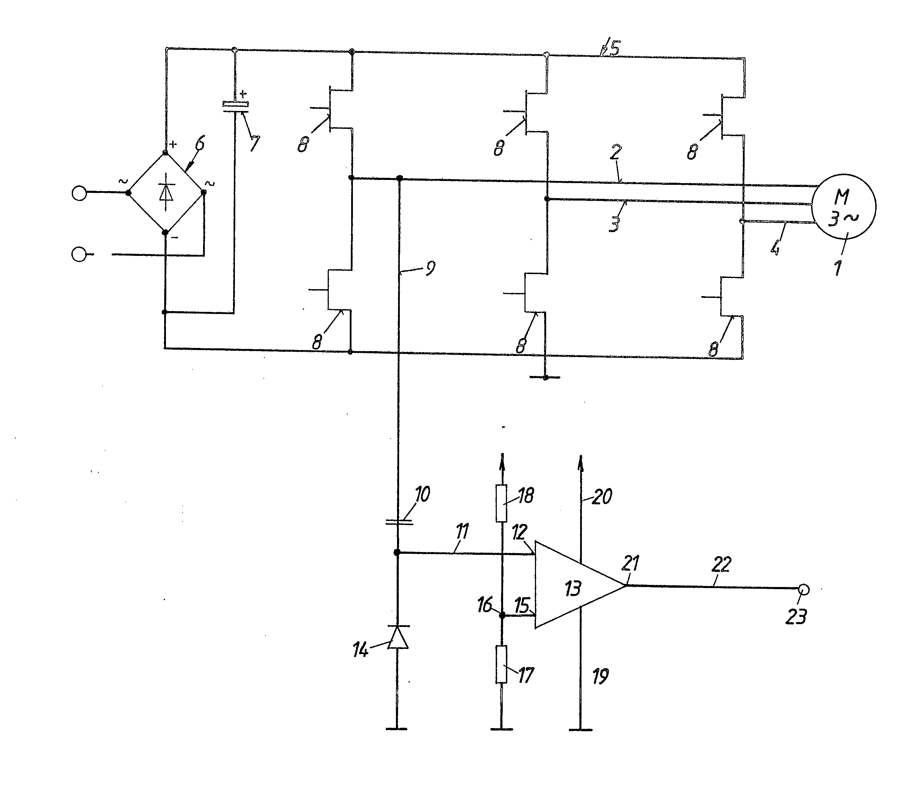

Die Erfindung wird im folgenden anhand des in der Zeichnung schematisch in einem Schaltbild dargestellten Ausführungsbeispiels näher erläutert.

Ein Drehstrom-Asynchronmotor 1 ist über Spannungsversorgungsleitungen 2, 3, 4 mit den Mittelpunkten einer hier nicht weiter interessierenden und an sich konventionell ausgeführten Wechselrichter-Drehstrombrücke 5 verbunden.

Die Drehstrombrücke 5 wird eingangsseitig mit an einem Gleichrichter 6 gerichteter Zwischenkreisspannung versorgt - ein Elektrolyt-Kondensator 7 zwischen den Gleichspannungsanschlüssen des Gleichrichters 6 dient noch zur Glättung. Die zwei Leistungstransistoren 8 jedes Brückenzweiges der Drehstrombrücke 5 - beispielsweise FETs - sind auf hier nicht weiter dargestellte Weise mit der Steuerelektronik verbunden und erlauben so die Steuerung des Drehfeldes für den Elektromotor 1.

Die Spannungsversorgungsleitung 2 ist über eine Leitung 9 mit einem Kondensator 10 verbunden, dessen anderer Anschluß einerseits über eine Leitung 11 am hier oberen Eingang 12 eines Komparators 13 und anderseits über eine Z-Diode 14 an Masse liegt. Die Z-Diode 14 dient nur der Überspannungssicherung und sperrt im Normalbetrieb.

Am in der Darstellung unteren Eingang 15 des Komparators 13 liegt der Mittelpunkt 16 eines zwei Widerstände 17, 18 aufweisenden Spannungsteilers, der einerseits ebenfalls an Masse liegt und mit an sich beliebiger Spannung versorgt ist. Mit 19 bzw. 20 sind die Leitungen zur Spannungsversorgung des Komparators 13 bezeichnet.

Der Ausgang 21 des Komparators 13 ist über eine Leitung 22 mit einer hier nur angedeuteten Auswerteschaltung 23 verbunden.

Nach dem zur Einleitung des Stillstandes des Elektromotors 1 erfolgten Sperren aller sechs Leistungstransistoren 8, wird einer der beiden in der Darstellung rechts unten befindlichen Leistungstransistoren 8 über hier nicht weiter dargestellte, dem Fachmann geläufige Steuerelemente wieder durchgeschaltet, womit die Spannungsversorgungsleitung 3 oder 4 an Masse liegt. Die andere erforderliche Verbindung für das vom auslaufenden Elektromotor induktiv induzierte Wechselspannungssignal läuft über die Spannungsversorgungsleitung 2 und die Leitung 9. Das über den Kondensator 10 gesiebte Wechselspannungssignal wird mit dem Signal vom Mittelpunkt 16 des Spannungsverteilers im Komparator 13 verglichen, worauf beim Unterschreiten des durch den Mittelpunkt 16 gelieferten Grenzwertsignals durch das am Eingang 12 des Komparators 13 liegende Wechselspannungssignal am Ausgang 21 ein Stillstandssignal erzeugt bzw. zur Weiterverarbeitung bereitgestellt wird.

Patentansprüche:

1. Verfahren zur Feststellung des Stillstandes eines Elektromotors, insbesonders eines Drehstrom-Asynchronmotors, dadurch gekennzeichnet, daß nach dem zur Einleitung des Stillstandes erfolgten Abschalten der Versorgungsspannung ein vom auslaufenden Elektromotor durch den Remanenzmagnetismus generiertes, induktiv induziertes Wechselspannungssignal über die Spannungsversorgungsleitungen ausgekoppelt wird, daß dieses in Frequenz und Amplitude der Drehzahl des auslaufenden Elektromotrs proportionale Signal nach Eliminierung der Gleichspannungsanteile mit einem vorgebbaren Grenzwertsignal verglichen wird, und daß bei Unterschreitung des Grenzwertsignals ein Stillstandssignal erzeugt und zur Weiterverwendung zur Verfügung gestellt wird.

2. Einrichtung zur Durchführung des Verfahrens nach Anspruch 1 zur Feststellung des Stillstandes eines über eine Drehstrombrücke mit je Brückenzweig zwei Leistungstransistoren gesteuerten Elektromotors, dadurch gekennzeichnet, daß nach dem zur Einleitung des Stillstandes erfolgten Sperren aller sechs Leistungstransistoren (8) einer mittels einer Steuerelektronik wieder durchschaltbar ist, wobei der zugehörige Zweig der Drehstrombrücke (5) an Masse liegt, daß eine vom so durchschaltbaren Leistungstransistor (8) unabhängige Phase der Spannungsversorgung des Elektromotors (1) über einen Kondensator (10) mit einem Eingang (12) eines Komparaotrs (13) verbunden ist, an dessen anderem Eingang (15) der Mittelpunkt (16) eines einerseits an Masse und anderseits an einer Vergleichsspannung liegenden Spannungsteilers (17, 18) liegt, und daß der Ausgang (21) des Komparators (13) mit einer Auswerteschaltung (23) für das Stillstandssignal verbunden ist.

3. Einrichtung nach Anspruch 2, dadurch gekennzeichnet, daß der Spannungsteiler (17, 18) einstellbar ist.

4. Einrichtung nach Anspruch 2 oder 3, dadurch gekennzeichnet, daß der komparatorseitige Anschluß des Kondensators (10) über ein bei Überspannung durchschaltendes Element, insbesondere eine Z-Diode (14), an Masse liegt.

1/1

0247994